# EUROPEAN PATENT SPECIFICATION

(11) **EP 2 178 143 B1**
(45) Date of publication and mention of the grant of the patent: **05.10.2016**
(21) Application number: 08792169.8
(22) Date of filing: 04.08.2008
(51) Int. Cl.: H01M 8/02, H01L 35/32, H01M 8/00, H01M 8/12

(54) **GENERATOR**
GENERATOR
GÉNÉRATEUR

(30) Priority: 06.08.2007 JP 2007204100
(43) Date of publication of application: 21.04.2010
(73) Proprietor: Kabushiki Kaisha Atsumitec, Shizuoka 431-0192 (JP)
(72) Inventor: UCHIYAMA, Naoki, Hamamatsu-shi Shizuoka 431-0192 (JP)
(74) Representative: advotec.
(86) International application number: PCT/JP2008/063972
(87) International publication number: WO 2009/020100

(56) References cited:
- EP-A1- 1 990 853
- EP-A2- 1 429 404
- JP-A- 04 280 073
- JP-A- 2000 173 640
- JP-A- 2000 243 412
- JP-A- 2002 141 077
- JP-A- 2002 280 017
- JP-A- 2006 527 905
- JP-A- 2007 200 710
- JP-A- 2007 227 306
- JP-A- 2008 078 334
- US-A1- 2006 216 559
- US-A1- 2006 292 411

## Description

### Technical Field

This invention relates to an electric power generation device using a fuel cell and a thermoelectric element.

### Background Art

Fuel cell devices including a fuel cell constructed by joining a fuel electrode and an air electrode to an electrolyte are known. In such fuel cell devices, electric power is generated by supplying fuel gas, etc. to the fuel cell while maintaining the fuel cell at a specified generation start temperature or higher by heating with an external heater or the like, for example.

Among such fuel cell devices, solid oxide fuel cell (SOFC) devices having a solid oxide fuel cell constructed by joining a fuel electrode (hydrogen electrode) and an air electrode (oxide electrode) to a solid oxide electrolyte can generate high electric power by supplying fuel gas to the fuel electrode and supplying air or the like to the air electrode. Further, the SOFC devices allow the use of not only hydrogen gas but also gas containing a large amount of carbon monoxide, as fuel gas, and also allow adoption of internal reforming process. Furthermore, use of heat emitted from the fuel cell allows the SOFC devices to have a reduced size and enhanced efficiency.

A common type of such SOFC device is a two chamber type, in which fuel gas and air or the like are supplied to a fuel electrode and an air electrode separated by a separator, respectively. A single chamber type SOFC device, in which a fuel cell not having a separator is arranged in a mixture of fuel gas and air or the like at high temperature, namely the generation start temperature or higher, has also been put to practical use.

In these fuel cell devices, however, a large part of thermal energy supplied to heat the fuel cell and of thermal energy emitted from the fuel cell is wastefully discharged to outside. The fuel cell devices therefore have room for further improvement in electric power generation efficiency. Thus, a technique of using a thermoelectric element connected to either the fuel electrode or the air electrode to convert thermal energy emitted from the fuel cell into electric power through the Seebeck effect of the thermoelectric element has been proposed. Such technique is disclosed in Unexamined Japanese Patent KOKAI Publication 2002-141077 (hereinafter referred to as Patent Document 1) and Unexamined Japanese Patent KOHYO Publication 2006-527905 (hereinafter referred to as Patent Document 2).

The techniques disclosed in Patent Documents 1 and 2 mentioned above require a thermoelectric element independent from the fuel electrode and the air electrode, resulting in an increase in the number of components constituting the electric power generation device, and thus an increase in device complexity and an increase in costs such as material costs. Further, the fuel cell and the thermoelectric element generate electric power, separately and therefore require complicated electrical connections between each other, resulting in an increase in costs such as material costs. Furthermore, for the fuel cell operating in the high-temperature environment, it is desirable to reduce the number of joins to enhance reliability. In the single chamber type SOFC device, in particular, the fuel cell is exposed to a high-temperature mixture of fuel gas and air or the like. Thus, an increase in the number of joins between the fuel cell and the thermoelectric element is undesirable from the viewpoint of reliability.

Additionally, prior art document EP 1 990 853 describes a power generating apparatus including a fuel cell comprising two thermoelectric conversion members, which function as a thermocouple producing electric power by utilizing the Seeback effect. The disclosure features a single cell solid oxide fuel cell, in which an anode, a cathode and an electrolyte is placed within a mixed reactant gas channel and a respective P- or N-type thermoelectric element being in contact with the anode or cathode and extend from inside of the mixed reactant gas channel to the outside of the channel.

### Disclosure of the Invention

The present invention has been made in view of the problems as mentioned above. The primary object of the present invention is to provide an electric power generation device using a fuel cell and a thermoelectric element which can offer enhanced reliability with simplified structure and electrical connections.

In order to achieve the above object, the electric power generation device according to the present invention is an electric power generation device comprising at least one single chamber type fuel cell including an electrolyte, a fuel electrode joined to the electrolyte and an air electrode separated from the fuel electrode and joined to the electrolyte, said fuel cell being arranged in a fuel gas channel through which high-temperature fuel gas flows to generate electric power.

In such electric power generation device, in the case where the fuel electrode extends from inside of the fuel gas channel to outside of the fuel gas channel, the fuel cell generates electric power, and the N-type thermoelectric element, which forms the fuel electrode, generates an electromotive force causing an electric current from outside of the fuel gas channel to inside of the fuel gas channel, due to a difference between the high temperature inside the fuel gas channel and the temperature outside the fuel gas channel, according to the Seebeck effect. Consequently, in this case, the electric power generation device can provide an electromotive force equaling the sum of the electromotive force of the fuel cell and the electromotive force of the N-type thermoelectric element.

In the case where the air electrode extends from inside of the fuel gas channel to outside of the fuel gas channel, on the other hand, the fuel cell generates electric power, and the P-type thermoelectric element, which forms the air electrode, generates an electromotive force causing an electric current from inside of the fuel gas channel to outside of the fuel gas channel, due to a difference between the high temperature inside the fuel gas channel and the temperature outside the fuel gas channel, according to the Seebeck effect. Consequently, in this case, the electric power generation device can provide an electromotive force equaling the sum of the electromotive force of the fuel cell and the electromotive force of the P-type thermoelectric element.

As stated above, in the electric power generation device according to the present invention, since the fuel electrode is an N-type thermoelectric element extending from inside of the fuel gas channel to outside of the fuel gas channel, or the air electrode is a P-type thermoelectric element extending from inside of the fuel gas channel to outside of the fuel gas channel, it is unnecessary to provide a join for an electrical connection between a fuel electrode and an N-type thermoelectric element or between an air electrode and a P-type thermoelectric element. This results in enhanced reliability and reduction in the number of components constituting the electric power generation device, and thus, simplified device structure and reduced costs.

The above electric power generation device further comprises an N-type thermoelectric element provided independently from the fuel cell and extending from inside of the fuel gas channel to outside of the fuel gas channel, for example. In this case, the air electrode of the fuel cell is a P-type thermoelectric element extending from inside of the fuel gas channel to outside of the fuel gas channel. The N-type thermoelectric element provided independently from the fuel cell and the P-type thermoelectric element of the fuel cell is electrically connected, outside the fuel gas channel.

In such electric power generation device, the N-type thermoelectric element provided independently from the fuel cell generates an electromotive force causing an electric current from outside of the fuel gas channel to inside of the fuel gas channel, due to a difference between the high temperature inside the fuel gas channel and the temperature outside the fuel gas channel, according to the Seebeck effect. Further, the P-type thermoelectric element, which forms the air electrode, generates an electromotive force causing an electric current from inside of the fuel gas channel to outside of the fuel gas channel, due to a difference between the high temperature inside the fuel gas channel and the temperature outside the fuel gas channel, according to the Seebeck effect. Since the N-type thermoelectric element provided independently from the fuel cell and the P-type thermoelectric element of the fuel cell are electrically connected outside the fuel gas channel, this electric power generation device can provide an electromotive force equaling the sum of the electromotive force of the fuel cell, the electromotive force of the N-type thermoelectric element provided independently from the fuel cell and the electromotive force of the P-type thermoelectric element forming the air electrode.

Alternatively, the electric power generation device may further comprise a P-type thermoelectric element provided independently from the fuel cell and extending from inside of the fuel gas channel to outside of the fuel gas channel, for example. In this case, the fuel electrode of the fuel cell is an N-type thermoelectric element extending from inside of the fuel gas channel to outside of the fuel gas channel. The P-type thermoelectric element provided independently from the fuel cell and the N-type thermoelectric element of the fuel cell is electrically connected outside the fuel gas channel.

In such electric power generation device, the P-type thermoelectric element provided independently from the fuel cell generates an electromotive force causing an electric current from inside of the fuel gas channel to outside of the fuel gas channel, due to a difference between the high temperature inside the fuel gas channel and the temperature outside the fuel gas channel, according to the Seebeck effect. Further, the N-type thermoelectric element, which forms the fuel electrode, generates an electromotive force causing an electric current from outside of the fuel gas channel to inside of the fuel gas channel, due to a difference between the high temperature inside the fuel gas channel and the temperature outside the fuel gas channel, according to the Seebeck effect. Since the P-type thermoelectric element provided independently from the fuel cell and the N-type thermoelectric element of the fuel cell are electrically connected outside the fuel gas channel, this electric power generation device can provide an electromotive force equaling the sum of the electromotive force of the fuel cell, the electromotive force of the P-type thermoelectric element provided independently from the fuel cell and the electromotive force of the N-type thermoelectric element forming the fuel electrode.

Alternatively, the electric power generation device may comprise a first fuel cell and a second fuel cell each provided as the above-mentioned fuel cell, for example. In this case, the air electrode of the first fuel cell may be a P-type thermoelectric element extending from inside of the fuel gas channel to outside of the fuel gas channel, and the fuel electrode of the second fuel cell may be an N-type thermoelectric element extending from inside of the fuel gas channel to outside of the fuel gas channel. The P-type thermoelectric element of the first fuel cell and the N-type thermoelectric element of the second fuel cell is electrically connected outside the fuel gas channel.

In the first fuel cell of such electric power generation device, the P-type thermoelectric element, which forms the air electrode, generates an electromotive force causing an electric current from inside of the fuel gas channel to outside of the fuel gas channel, due to a difference between the high temperature inside the fuel gas channel and the temperature outside the fuel gas channel, according to the Seebeck effect. In the second fuel cell, on the other hand, the N-type thermoelectric element, which forms the fuel electrode, generates an electromotive force causing an electric current from outside of the fuel gas channel to inside of the fuel gas channel, due to a difference between the high temperature inside the fuel gas channel and the temperature outside the fuel gas channel, according to the Seebeck effect. Since the P-type thermoelectric element of the first fuel cell and the N-type thermoelectric element of the second fuel cell are electrically connected outside the fuel gas channel, this electric power generation device can provide an electromotive force equaling the sum of the electromotive forces of the first and second fuel cells, the electromotive force of the P-type thermoelectric element forming the air electrode of the first fuel cell and the electromotive force of the N-type thermoelectric element forming the fuel electrode of the second fuel cell.

Alternatively, the fuel cell of the electric power generation device may include an air electrode composed of a P-type thermoelectric element and extending from inside of the fuel gas channel to outside of the fuel gas channel, and a fuel electrode placed completely inside the fuel gas channel, for example.

In such fuel cell of the electric power generation device, the P-type thermoelectric element, which forms the air electrode, generates an electromotive force causing an electric current from inside of the fuel gas channel to outside of the fuel gas channel, due to a difference between the high temperature inside the fuel gas channel and the temperature outside the fuel gas channel, according to the Seebeck effect. Consequently, this electric power generation device can provide an electromotive force equaling the sum of the electromotive force of the fuel cell and the electromotive force of the P-type thermoelectric element forming the air electrode of the fuel cell.

Alternatively, the fuel cell of the electric power generation device may include a fuel electrode composed of an N-type thermoelectric element and extending from inside of the fuel gas channel to outside of the fuel gas channel, and an air electrode placed completely inside the fuel gas channel, for example.

In such fuel cell of the electric power generation device, the N-type thermoelectric element, which forms the fuel electrode, generates an electromotive force causing an electric current from outside of the fuel gas channel to inside of the fuel gas channel, due to a difference between the high temperature inside the fuel gas channel and the temperature outside the fuel gas channel, according to the Seebeck effect. Consequently, this electric power generation device can provide an electromotive force equaling the sum of the electromotive force of the fuel cell and the electromotive force of the N-type thermoelectric element forming the fuel electrode of the fuel cell.

Alternatively, the electric power generation device may comprise a first fuel cell and a second fuel cell each provided as the above-mentioned fuel cell, for example. In this case, the first and second fuel cells may each include an air electrode composed of a P-type thermoelectric element and extending from inside of the fuel gas channel to outside of the fuel gas channel, and a fuel electrode composed of an N-type thermoelectric element and extending from inside of the fuel gas channel to outside of the fuel gas channel. The P-type thermoelectric element of the first fuel cell and the N-type thermoelectric element of the second fuel cell is electrically connected outside the fuel gas channel.

In each of such first and second fuel cells of the electric power generation device, the P-type thermoelectric element, which forms the air electrode, generates an electromotive force causing an electric current from inside of the fuel gas channel to outside of the fuel gas channel, due to a difference between the high temperature inside the fuel gas channel and the temperature outside the fuel gas channel, according to the Seebeck effect, and the N-type thermoelectric element, which forms the fuel electrode, generates an electromotive force causing an electric current from outside of the fuel gas channel to inside of the fuel gas channel, due to a difference between the high temperature inside the fuel gas channel and the temperature outside the fuel gas channel, according to the Seebeck effect. Since the P-type thermoelectric element of the first fuel cell and the N-type thermoelectric element of the second fuel cell are electrically connected outside the fuel gas channel, this electric power generation device can provide an electromotive force equaling the sum of the electromotive forces of the first and second fuel cells, the electromotive forces of the P-type thermoelectric elements forming the air electrodes of the first and second fuel cells and the electromotive forces of the N-type thermoelectric elements forming the fuel electrodes of the first and second fuel cells.

Alternatively, the fuel cell of the electric power generation device may include an air electrode composed of a P-type thermoelectric element and extending from inside of the fuel gas channel to outside of the fuel gas channel, and a fuel electrode composed of an N-type thermoelectric element and extending from inside of the fuel gas channel to outside of the fuel gas channel.

In such fuel cell of the electric power generation device, the P-type thermoelectric element, which forms the air electrode, generates an electromotive force causing an electric current from inside of the fuel gas channel to outside of the fuel gas channel, due to a difference between the high temperature inside the fuel gas channel and the temperature outside the fuel gas channel, according to the Seebeck effect, and the N-type thermoelectric element, which forms the fuel electrode, generates an electromotive force causing an electric current from outside of the fuel gas channel to inside of the fuel gas channel, due to a difference between the high temperature inside the fuel gas channel and the temperature outside the fuel gas channel, according to the Seebeck effect. Consequently, this electric power generation device can provide an electromotive force equaling the sum of the electromotive force of the fuel cell, the electromotive force of the P-type thermoelectric element forming the air electrode of the fuel cell and the electromotive force of the N-type thermoelectric element forming the fuel electrode of the fuel cell.

### Brief Description of the Drawings

FIG. 1 is a cross-sectional view showing schematic structure of an electric power generation device according to a first embodiment of the present invention, along the axis of a gas channel;
FIG. 2 is a cross-sectional view of the electric power generation device according to the first embodiment, viewed as indicated by arrows II, II in FIG. 1;
FIG. 3 is a cross-sectional view of the electric power generation device according to the first embodiment, viewed as indicated by arrows III, III in FIG. 1;
FIG. 4 is an electrical connection diagram showing an example for increasing output electric power of the electric power generation device according to the first embodiment;
FIG. 5 is an electrical connection diagram showing an example for increasing output electric current of the electric power generation device according to the first embodiment;
FIG. 6 is an electrical connection diagram showing an example for increasing output voltage and output electric current of the electric power generation device according to the first embodiment;
FIG. 7 is a cross-sectional view showing schematic structure of an electric power generation device according to a second embodiment of the present invention, along the axis of a gas channel;
FIG. 8 is a cross-sectional view of the electric power generation device according to the second embodiment, viewed as indicated by arrows VIII, VIII in FIG. 7;
FIG. 9 is a cross-sectional view showing schematic structure of an electric power generation device according to a variant of the second embodiment, along the axis of a gas channel;
FIG. 10 is a cross-sectional view showing schematic structure of an electric power generation device according to a third embodiment of the present invention, along the axis of a gas channel;
FIG. 11 is a cross-sectional view of the electric power generation device according to the third embodiment, viewed as indicated by arrows XI, XI in FIG. 10;
FIG. 12 is a cross-sectional view showing schematic structure of an electric power generation device according to a first variant of the third embodiment, along the axis of a gas channel; and
FIG. 13 is a cross-sectional view showing schematic structure of an electric power generation device according to a second variant of the third embodiment, along the axis of a gas channel.

### Best Mode of Carrying out the Invention

Referring to the drawings, electric power generation devices according to the present invention will be described below.

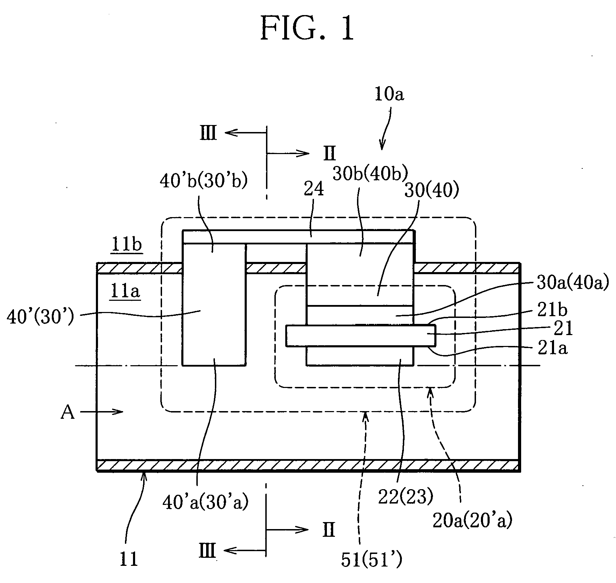

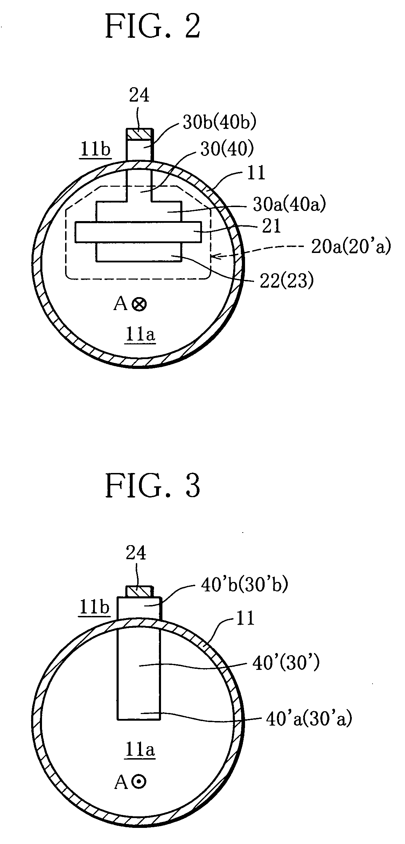

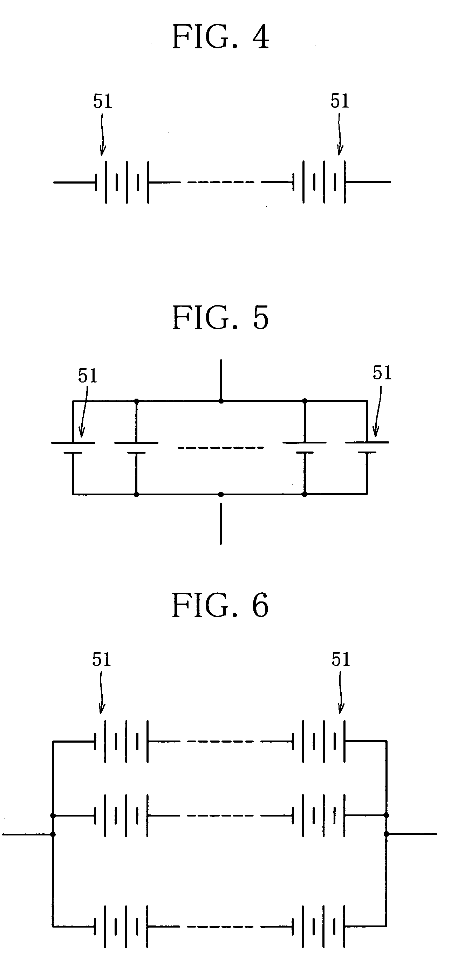

First, referring to FIGS. 1 to 6, an electric power generation device 10a according to a first embodiment of the present invention will be described. FIG. 1 is a cross-sectional view showing schematic structure of the electric power generation device 10a along the axis of a gas channel (fuel gas channel) 11. FIGS. 2 and 3 are cross-sectional views viewed as indicated by arrows II, II and arrows III, III in FIG. 1, respectively. Fuel gas flows through the inside 11a of the gas channel 11 in the direction of arrow A in FIG. 1. Hereinafter, the direction of the fuel gas flow will be sometimes referred to as "flowing direction A". FIGS. 4 to 6 are electrical connection diagrams each showing an example for increasing output electric power of the electric power generation device 10a in a different manner.

The electric power generation device 10a comprises a gas channel 11, a fuel cell 20a, a P-type thermoelectric element 30 and an N-type thermoelectric element 40'. The fuel cell 20a comprises a solid oxide electrolyte 21, a fuel electrode 22 and the P-type thermoelectric element 30 that functions as an air electrode. The fuel cell 20a is located in the inside 11a of the gas channel 11 by means of a support member not shown, to function as a single chamber type solid oxide fuel cell. The P-type thermoelectric element 30 has a first end 30a and a second end 30b, and the N-type thermoelectric element 40' has a first end 40a' and a second end 40b'.

As shown in FIG. 1, in the electric power generation device 10a, the N-type thermoelectric element 40' is arranged upstream of the P-type thermoelectric element 30 in the flowing direction A. As seen in FIGS. 1 to 3, the P-type thermoelectric element 30 and the N-type thermoelectric element 40' are arranged along a plane containing the axis of the gas channel 11, apart from each other. The P-type thermoelectric element 30 and the N-type thermoelectric element 40' each extend through the wall of the gas channel 11. Thus, the P-type thermoelectric element 30 has a second end 30b-side portion located in the outside 11b of the gas channel 11, and the rest therefore is located in the inside 11a of the gas channel 11. Likewise, the N-type thermoelectric element 40' has a second end 40b' -side portion located in the outside 11b of the gas channel 11, and the rest thereof is located in the inside 11a of the gas channel 11. Further, as shown in FIG. 1, the second end 30b of the P-type thermoelectric element 30 and the second end 40'b of the N-type thermoelectric element 40' are connected by a conductor 24 so that the P-type thermoelectric element 30 and the N-type thermoelectric element 40' are electrically connected in series. Incidentally, the second end 30b of the P-type thermoelectric element 30 and the second end 40'b of the N-type thermoelectric element 40' may be directly connected together. The fuel cell 20a and the N-type thermoelectric element 40' thus constitute an electric power generation module 51. Naturally, the P-type thermoelectric element 30 and the N-type thermoelectric element 40' are electrically insulated from the gas channel 11 with an insulator not shown.

Next, the geometry of the fuel cell 20a, the P-type thermoelectric element 30, the N-type thermoelectric element 40', etc. will be described.

As shown in FIGS. 1 and 2, the solid oxide electrolyte 21 and the fuel electrode 22 are each approximately a flat plate in shape, and the fuel electrode 22 is joined to a first surface 21a of the solid oxide electrolyte 21. The solid oxide electrolyte 21 and the fuel electrode 22 joined together are arranged parallel to the flowing direction A, near the axis of the gas channel 11, for example. The fuel electrode 22 is thus arranged to be exposed to the fuel gas flow. The solid oxide electrolyte 21 is 55mm in length, namely the dimension parallel to the flowing direction A, 15mm in width and 0.5mm in thickness, for example. The fuel electrode 22 is 50mm in length, namely the dimension parallel to the flowing direction A, 10mm in width and 0.1mm in thickness, for example.

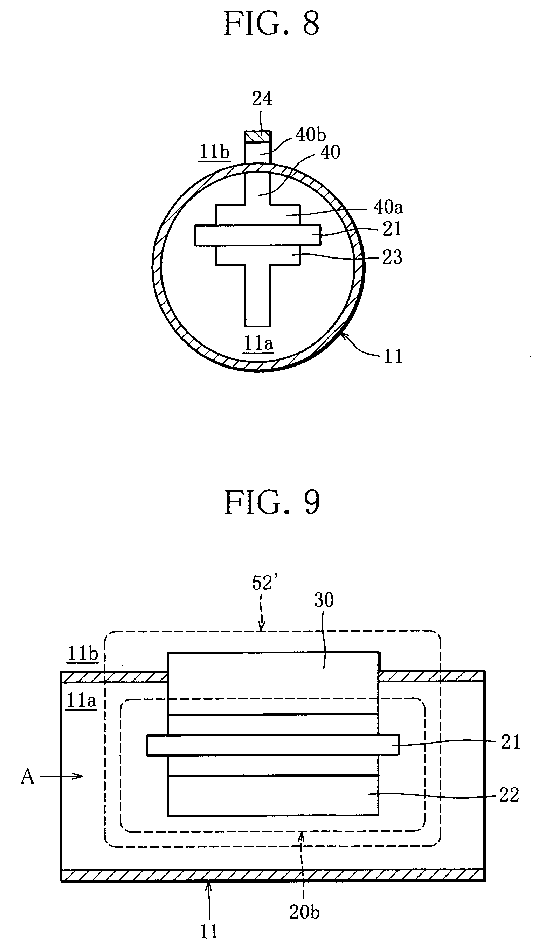

As shown in FIG. 2, the P-type thermoelectric element 30 is approximately a T shape in cross section, and the first end 30a of the P-type thermoelectric element 30 constituting a head of the T is joined to a second surface 21b of the solid oxide electrolyte 21. The P-type thermoelectric element 30 has a geometry such that the head portion of the T-shape is 10mm in width, 0.1mm in thickness and 50mm in length, namely the dimension parallel to the flowing direction A and that the portion between the first end 30a and the second end 30b is 8mm in thickness, for example. The N-type thermoelectric element 40' is a flat plate in shape, and 50mm in length, namely the dimension parallel to the flowing direction A, 30mm in the vertical dimension in FIG. 1, and 8 mm in thickness, for example. The P-type thermoelectric element 30 and the N-type thermoelectric element 40' each have a length appropriate for the diameter of the gas channel 11. Further, as seen in FIGS. 1 to 3, the P-type thermoelectric element 30 and the N-type thermoelectric element 40' are arranged with each of their plate-shaped portions parallel to the flowing direction A and exposed to the fuel gas flow.

The composition of the fuel cell 20a, the respective thermoelectric elements, etc. is as follows:
The solid oxide electrolyte 21 of the fuel cell 20a can be formed of 8mol-YSZ (yttria stabilized zirconia), 5mol-YSZ, SDC (scandia doped ceria), GDC (gadolinium doped ceria), ScSZ (scandia stabilized zirconia) or the like, for example. The fuel electrode 22 can be formed of NiO+YSZ, NiO+SDC, NiO+GDC, LSCM (lanthanum strontium cobalt manganite), FeO₃ or the like, for example.

The P-type thermoelectric element 30 capable of functioning as an air electrode of the fuel cell 20a is formed by firing powder of a metallic material, such as Ba_{0.5}Sr_{0.5}Co_{0.8}Fe_{0.2}O₃₂+d (BSCF, barium strontium cobalt iron oxide), Sr₄Fe_{5.88}Ni_{0.12}O₁₃+d (strontium iron nickel oxide), Sr_{3.84}Ca_{0.16}Fe_{5.88}Ni_{0.12}O₁₃+d (strontium calcium iron nickel oxide), Sr_{1.2}Ca_{2.8}Fe_{5.88}Ni_{0.12}O₁₃+d(strontium calcium iron nickel oxide), Ca₄Fe_{5.88}Ni_{0.12}O₁₃+d (calcium iron nickel oxide), Sr_{3.5}La_{0.5}Fe_{5.88} Ni_{0.12}O₁₃+d (strontium lanthanum iron nickel oxide), Sr_{3.5}La_{0.5}Fe₆O₁₃+d (strontium lanthanum iron oxide), Ca_{3.5}La_{0.5}Fe_{5.88}Ni_{0.12}O₁₃+d (calcium lanthanum iron nickel oxide) or the like, for example. It is formed from powder of one or more of these metallic materials.

The N-type thermoelectric element 40' is an electrode not functioning as a fuel electrode or an air electrode of the fuel cell 20a, and formed by firing powder of a metallic material such as Fe₂VAl_{0.9}Si_{0.1}. It is formed from powder of one or more of such metallic materials.

Next, the operation of the electric power generation device 10a will be described.

In the electric power generation device 10a, fuel gas is led into the gas channel 11 in the direction of arrow A in FIG. 1. When the fuel gas, which is, for example, exhaust gas emitted from a gasoline engine or the like (exhaust gas containing CHx, COx, air, etc. at a temperature of 500 to 1000°C or higher, for example) is led into the gas channel 11, the exhaust gas contacts and heats the N-type thermoelectric element 40', the P-type thermoelectric element 30, the fuel cell 20a, etc. and then exits the gas channel 11.

The fuel cell 20a thus heated reaches an electric power generation start temperature (500 to 1000°C, for example), so that oxygen ions (O²⁻) are formed from air in the exhaust gas at the P-type thermoelectric element 30 functioning as an air electrode of the fuel cell 20a. The oxygen ions move from the P-type thermoelectric element 30 (air electrode) to the fuel electrode 22 through the solid oxide electrolyte 21. In this manner, the fuel cell 20a generates an electromotive force causing an electric current from the fuel electrode 22 to the P-type thermoelectric element 30 (air electrode). The oxygen ions moving to the fuel electrode 22 react with CHx and COx in the exhaust gas to form carbon dioxide (CO₂) and water (H₂O) at the fuel electrode 22. Thus, the fuel cell 20a generates electric power and also cleans the exhaust gas by converting CHx and COx in the exhaust gas into carbon dioxide and water (water vapor).

Further, the P-type thermoelectric element 30 and the N-type thermoelectric element 40' each generates an electromotive force due to a temperature difference between the inside 11a of the gas channel 11, through which exhaust gas at 500 to 1000°C flows, and the outside 11b at normal temperature, for example. Specifically, the P-type thermoelectric element 30 generates an electromotive force causing an electric current from the first end 30a (high-temperature side) to the second end 30b (low-temperature side). The N-type thermoelectric element 40' generates an electromotive force causing an electric current from the second end 40'b (low-temperature side) to the first end 40'a (high-temperature side). Thus, the electric power generation module 51 generates an electromotive force causing an electric current from the fuel electrode 22 of the fuel cell 20a to the first end 40'a of the N-type thermoelectric element 40', which electromotive force equals the sum of the electromotive force of the fuel cell 20a, the electromotive force of the P-type thermoelectric element 30 and the electromotive force of the N-type thermoelectric element 40'. The second end 30b of the P-type thermoelectric element 30 and the second end 40'b of the N-type thermoelectric element 40' can each be considered as a cold junction of a thermocouple.

As stated above, in the electric power generation device 10a according to the first embodiment, since the P-type thermoelectric element 30 extending from the inside 11a of the gas channel 11 to the outside 11b is an air electrode, it is unnecessary to provide a join for an electrical connection between the P-type thermoelectric element 30 and an air electrode. This results in enhanced reliability and reduction in the number of components constituting the electric power generation device 10a, and thus, simplified device structure and reduced costs.

The electromotive force of the fuel cell 20a is a little greater than 1 volt, and the electromotive forces of the P-type thermoelectric element 30 and the N-type thermoelectric element 40' are each approximately 0.03 volt. Thus, it is possible to obtain a desired DC or AC voltage by connecting a plurality of electric power generation modules 51 in series as shown in FIG. 4 and using an inverter circuit or the like, not shown. In FIG. 4, each electric power generation module 51 is represented by a circuit diagram symbol for a cell. Further, it is possible to increase the output current of the electric power generation device 10a by connecting a plurality of electric power generation modules 51 in parallel as shown in FIG. 5. Alternatively, it is possible to increase both the output voltage and the output current of the electric power generation device 10a by connecting a plurality of electric power generation modules 51 in series and in parallel as shown in FIG. 6. Also in FIGS. 5 and 6, each electric power generation module 51 is represented by a circuit diagram symbol for a cell.

Next, a variant of the first embodiment will be described.

The fuel cell 20 in the electric power generation module 51 can be changed into a fuel cell 20'a by replacing the fuel electrode 22 with an air electrode 23 and replacing the P-type thermoelectric element 30 with an N-type thermoelectric element 40. In this case, further the N-type thermoelectric element 40' is replaced with a P-type thermoelectric element 30'. The components of the variant different from the components of the electric power generation module 51 are denoted by reference characters in brackets in FIGS. 1 to 3. The electromotive force of this variant electric power generation module, which will be referred to as "electric power generation module 51'", is reverse to that of the electric power generation module 51. In other words, the electric power generation module 51' generates an electromotive force causing an electric current from the first end 30'a of the P-type thermoelectric element 30' to the air electrode 23.

Here, the N-type thermoelectric element 40 can function as a fuel electrode of the fuel cell 20'a, and is formed, for example by diffusing platinum or nickel oxide in any of a titanium oxide-based alloy, a manganese oxide-based alloy and a zinc oxide-based alloy, and further diffusing an ion-conductive ceramic, specifically a ceria-based alloy ((60vol%-40vol%Ni)-GDC) or a zirconia-based alloy (ScSZ) therein, and firing the resultant material, where vol% represents volume %, GDC gadolinium doped ceria, and ScSZ scandia stabilized zirconia.

The P-type thermoelectric element 30' is an electrode not functioning as a fuel electrode or an air electrode of the fuel cell 20'a, and formed by firing powder of a metallic material such as Fe₂V_{0.9}Ti_{0.1}Al. It is formed from powder of one or more of such metallic materials.

In the electric power generation device structured as described above, since the N-type thermoelectric element 40 extending from the inside 11a of the gas channel 11 to the outside 11b is a fuel electrode, it is unnecessary to provide a join for an electrical connection between the N-type thermoelectric element 40 and a fuel electrode. This results in enhanced reliability and reduction in the number of components constituting the electric power generation device, and thus, simplified device structure and reduced costs.

In the above-described first embodiment and variant thereof, either of the P-type thermoelectric element 30 (or 30') and the N-type thermoelectric element 40' (or 40) may be upstream of the other in the flowing direction A. If the cross section of the gas channel 11 orthogonal to the flowing direction A is an ellipse or a flattened shape, for example, the P-type thermoelectric element 30 (or 30') and the N-type thermoelectric element 40' (or 40) may be arranged on the same plane orthogonal to the flowing direction A.

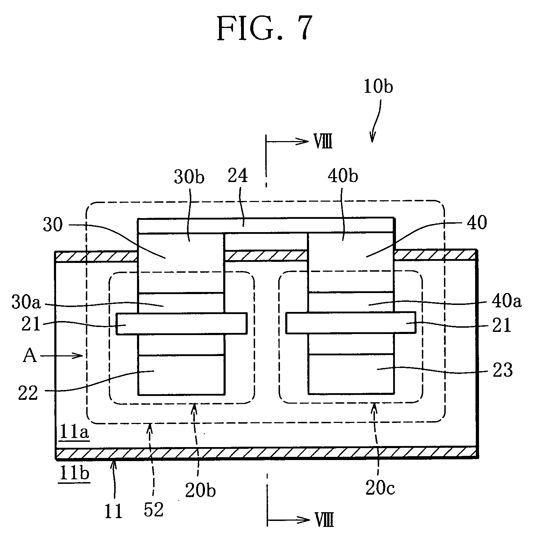

Next, referring to FIGS. 7 and 8, an electric power generation device 10b according to a second embodiment of the present invention will be described. FIG. 7 is a cross-sectional view showing schematic structure of the electric power generation device 10b, along the axis of a gas channel 11, and FIG. 8 is a cross-sectional view, viewed as indicated by arrows VIII, VIII in FIG. 7. The components similar in function to those in the first embodiment will be assigned the same reference characters and the description thereof will be omitted.

The electric power generation device 10b comprises a gas channel 11, a first fuel cell 20b and a second fuel cell 20c. The first fuel cell 20b is arranged upstream of the second fuel cell 20c in the flowing direction A. The first fuel cell 20b comprises a solid oxide electrolyte 21, a fuel electrode 22 and a P-type thermoelectric element 30 capable of functioning as an air electrode. The second fuel cell 20c comprises a solid oxide electrolyte 21, an air electrode 23 and an N-type thermoelectric element 40 capable of functioning as a fuel electrode.

The P-type thermoelectric element 30 and the N-type thermoelectric element 40 are arranged along a plane containing the axis of the gas channel 11, apart from each other. The P-type thermoelectric element 30 and the N-type thermoelectric element 40 each extend through the wall of the gas channel 11. Thus, the P-type thermoelectric element 30 has a second end 30b-side portion located in the outside 11b of the gas channel 11, and the rest thereof is located in the inside 11a of the gas channel 11. Likewise, the N-type thermoelectric element 40 has a second end 40b-side portion located in the outside 11b of the gas channel 11, and the rest thereof is located in the inside 11a of the gas channel 11. Consequently, the P-type thermoelectric element 30 and the N-type thermoelectric element 40 can each generate an electromotive force according to the Seebeck effect. Further, as seen in FIG. 7, the second end 30b of the P-type thermoelectric element 30 and the second end 40b of the N-type thermoelectric element 40 are connected by a conductor 24 so that the P-type thermoelectric element 30 and the N-type thermoelectric element 40 are electrically connected in series.

Thus, the first fuel cell 20b and the second fuel cell 20c are electrically connected in series to constitute an electric power generation module 52. In the electric power generation device 10b according to the present embodiment, the fuel electrode 22 and the air electrode 23 are a T shape in cross section as well as the P-type thermoelectric element 30 and the N-type thermoelectric element, and placed completely in the inside 11a of the gas channel 11. The fuel electrode 22 and the air electrode 23 may however be a flat plate in shape, as in the electric power generation device 10a according to the first embodiment.

In the electric power generation device 10b, exhaust gas that has entered the gas channel 11 heats the first fuel cell 20b and the second fuel cell 20c and then exits the gas channel 11, where the first fuel cell 20b generates an electromotive force causing an electric current from the fuel electrode 22 to the P-type thermoelectric element 30 (air electrode) and the P-type thermoelectric element 30 generates an electromotive force causing an electric current from the first end 30a to the second end 30b. The second fuel cell 20c, on the other hand, generates an electromotive force causing an electric current from the N-type thermoelectric element 40 (fuel electrode) to the air electrode 23 and the N-type thermoelectric element 40 generates an electromotive force causing an electric current from the second end 40b to the first end 40a. Thus, the electric power generation module 52 generates an electromotive force causing an electric current from the fuel electrode 22 of the first fuel cell 20b to the air electrode 23 of the second fuel cell 20c, which electromotive force equals the sum of the electromotive forces of the first fuel cell 20b, the second fuel cell 20c, the P-type thermoelectric element 30 and the N-type thermoelectric element 40. Naturally, as in the first embodiment, it is possible to electrically connect a plurality of electric power generation modules 52 in series and/or in parallel as shown in FIGS. 4 to 6.

As stated above, in the electric power generation device 10b according to the second embodiment, since the P-type thermoelectric element 30 extending from the inside 11a of the gas channel 11 to the outside 11b is an air electrode of the first fuel cell 20b, the first fuel cell 20b does not need to have a join for an electrical connection between the P-type thermoelectric element 30 and an air electrode. Further, since the N-type thermoelectric element 40 extending from the inside 11a of the gas channel 11 to the outside 11b is a fuel electrode of the second fuel cell 20c, the second fuel cell 20c does not need to have a join for an electrical connection between the N-type thermoelectric element 40 and a fuel electrode. This results in enhanced reliability and reduction in the number of components constituting the electric power generation device 10b, and thus, simplified device structure and reduced costs.

Next, a variant of the second embodiment will be described.

As shown in FIG. 9, this variant includes only a first fuel cell 20b of the electric power generation device 10b, not a second fuel cell 20c thereof. In this case, an electric power generation module 52' is made up only of the first fuel cell 20b and a P-type thermoelectric element 30. The electromotive force of the electric power generation module 52' is the sum of the electromotive force of the first fuel cell 20b and the electromotive force of the P-type thermoelectric element 30.

Also in such electric power generation device, since the P-type thermoelectric element 30 extending from the inside 11a of the gas channel 11 to the outside 11b is an air electrode, it is unnecessary to provide a join for an electrical connection between the P-type thermoelectric element 30 and an air electrode. This results in enhanced reliability and reduction in the number of components constituting the electric power generation device, and thus, simplified device structure and reduced costs.

The variant may include only a second fuel cell 20c in place of the first fuel cell 20b. In this case, the electromotive force obtained equals the sum of the electromotive force of the second fuel cell 20c and the electromotive force of the N-type thermoelectric element 40. This variant likewise provides enhanced reliability and enables reduction in the number of components constituting the electric power generation device, and thus, simplified device structure and reduction in costs.

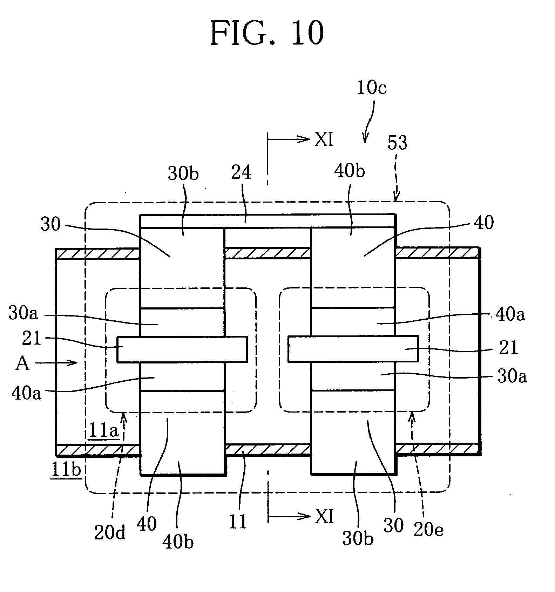

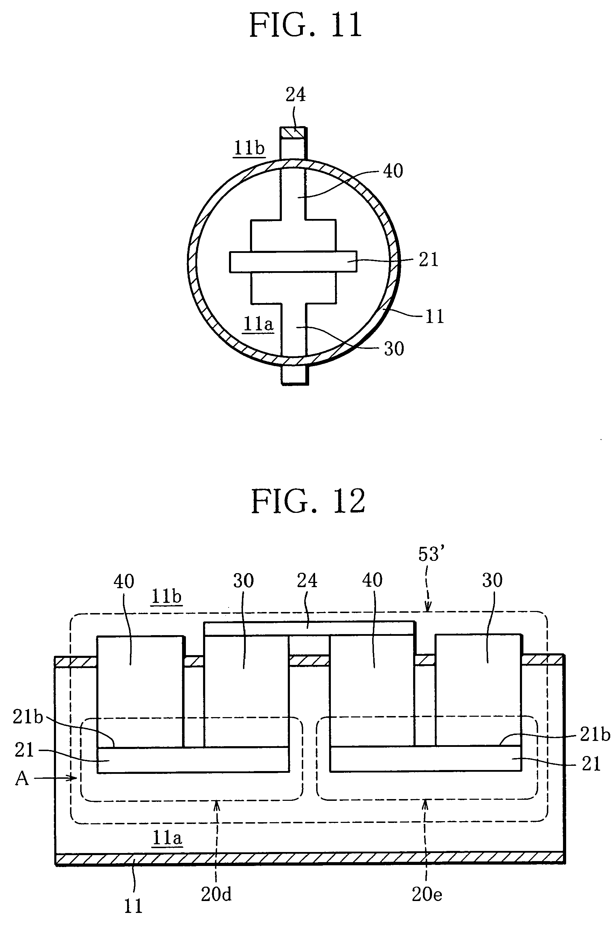

Next, referring to FIGS. 10 and 11, an electric power generation device 10c according to a third embodiment of the present invention will be described. FIG. 10 is a cross-sectional view showing schematic structure of the electric power generation device 10c, along the axis of a gas channel 11, and FIG. 11 is a cross-sectional view, viewed as indicated by arrows XI, XI in FIG. 10. The components similar in function to those in the preceding embodiments will be assigned the same reference characters and the description thereof will be omitted.

The electric power generation device 10c comprises a gas channel 11, a first fuel cell 20d and a second fuel cell 20e. The first fuel cell 20d is arranged upstream of the second fuel cell 20e in the flowing direction A. The first fuel cell 20d and the second fuel cell 20e each comprise a solid oxide electrolyte 21, a P-type thermoelectric element 30 capable of functioning as an air electrode and an N-type thermoelectric element 40 capable of functioning as a fuel electrode.

As seen in FIG. 10, in the first fuel cell 20d, a first end 30a of the P-type thermoelectric element 30 and a first end 40a of the N-type thermoelectric element 40 are joined to the solid oxide electrolyte 21, respectively, so that the solid oxide electrolyte 21 is interposed between the P-type thermoelectric element 30 and the N-type thermoelectric element 40. Likewise, in the second fuel cell 20e, a first end 40a of the N-type thermoelectric element 40 and a first end 30a of the P-type thermoelectric element 30 are joined to the solid oxide electrolyte 21, respectively, so that the solid oxide electrolyte 21 is interposed between the P-type thermoelectric element 30 and the N-type thermoelectric element 40.

As seen in FIG. 10, the P-type thermoelectric element 30 of the first fuel cell 20d and the N-type thermoelectric element 40 of the second fuel cell 20e are arranged along a plane containing the axis of the gas channel 11, apart from each other, and extend through the wall of the gas channel 11 in the same direction. The N-type thermoelectric element 40 of the first fuel cell 20d and the P-type thermoelectric element 30 of the second fuel cell 20e are arranged apart from each other, and extend through the wall of the gas channel 11 in the direction opposite to the direction that the P-type thermoelectric element 30 of the first fuel cell 20d and the N-type thermoelectric element 40 of the second fuel cell 20e extend. In this arrangement, the two P-type thermoelectric elements 30 and the two N-type thermoelectric elements 40 can each generate an electromotive force according to the Seebeck effect. A second end 30b of the P-type thermoelectric element 30 of the fuel cell 20d and a second end 40b of the N-type thermoelectric element 40 of the fuel cell 20e are electrically connected by a conductor 24.

Thus, the first fuel cell 20d and the second fuel cell 20e are electrically connected in series to constitute an electric power generation module 53, which generates an electromotive force causing an electric current from the N-type thermoelectric element 40 (fuel electrode) of the first fuel cell 20d to the P-type thermoelectric element 30 (air electrode) of the second fuel cell 20e. The electromotive force of the electric power generation module 53 equals the sum of the electromotive forces of the first fuel cell 20d and the second fuel cell 20e and the electromotive forces of the two P-type thermoelectric elements 30 and the two N-type thermoelectric elements 40. Incidentally, the P-type thermoelectric element 30 and the N-type thermoelectric element 40 of the first fuel cell 20d as well as those of the second fuel cell 20e can be each considered as a thermocouple with a warm junction located in the inside 11a of the gas channel 11.

As stated above, in the first fuel cell 20d as well as the second fuel cell 20e of the electric power generation device 10c according to the third embodiment, the P-type thermoelectric element 30 extending from the inside 11a of the gas channel 11 to the outside 11b is an air electrode, and the N-type thermoelectric element 40 extending from the inside 11a of the gas channel 11 to the outside 11b is a fuel electrode. Thus, the first fuel cell 20d as well as the second fuel cell 20e needs to have no joints for electrical connections between the P-type thermoelectric element 30 and an air electrode and between the N-type thermoelectric element 40 and a fuel electrode. This results in enhanced reliability and reduction in the number of components constituting the electric power generation device 10c, and thus, simplified device structure and reduced costs.

Next, a first variant of the third embodiment will be described.

As shown in FIG. 12, in this variant of the electric power generation device 10c, the shape of the solid oxide electrolytes 21 allows all the P-type thermoelectric elements 30 and the N-type thermoelectric elements 40 to be joined on the same side surface 21b of each solid oxide electrolyte 21. In this case, all the P-type thermoelectric elements 30 and the N-type thermoelectric elements 40 are arranged along a plane containing the axis of the gas channel 11, apart from one another, and extend through the wall of the gas channel 11 in the same direction. The P-type thermoelectric element 30 (air electrode) of the first fuel cell 20d and the N-type thermoelectric element 40 (fuel electrode) of the second fuel cell 20e are electrically connected to constitute an electric power generation module 53'. The electromotive force of the electric power generation module 53' is the sum of the electromotive forces of the first fuel cell 20d and the second fuel cell 20e and the electromotive forces of the two P-type thermoelectric elements 30 and the two N-type thermoelectric elements 40, as in the third embodiment.

Also in this case, joins for electrical connections between the P-type thermoelectric element 30 and an air electrode and between the N-type thermoelectric element 40 and a fuel electrode are unnecessary. This results in enhanced reliability and reduction in the number of components constituting the electric power generation device, and thus, simplified device structure and reduced costs.

Next, a second variant of the third embodiment will be described.

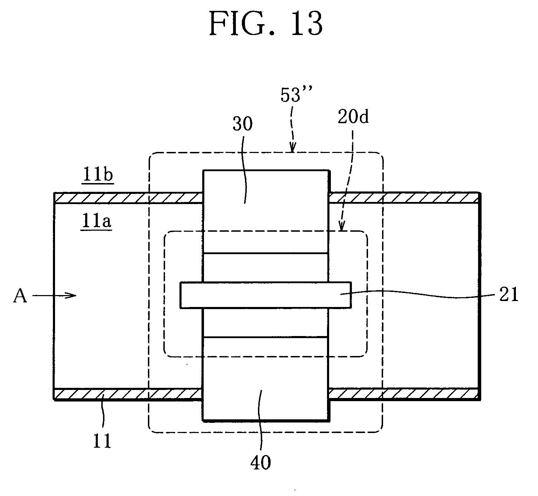

As shown in FIG. 13, the second variant includes only a first fuel cell 20d of the above-described electric power generation device 10c, not a second fuel cell 20e thereof. In this case, the electric power generation module 53" is made up only of the first fuel cell 20d, a P-type thermoelectric element 30 (air electrode) and an N-type thermoelectric element 40 (fuel electrode), and the electromotive force thereof is the sum of the electromotive force of the first fuel cell 20d and the electromotive forces of the P-type thermoelectric element 30 and the N-type thermoelectric element 40.

Also in this case, it is unnecessary to provide joins for electrical connections between the P-type thermoelectric element 30 and an air electrode and between the N-type thermoelectric element 40 and a fuel electrode. This results in enhanced reliability and reduction in the number of components constituting the electric power generation device, and thus, simplified device structure and reduced costs.

The electric power generation device according to present invention is not restricted to the above-described embodiments, but can be modified appropriately without departing from the scope as defined by the claims. For example,
the way of arranging fuel cells and thermoelectric elements inside the gas channel is not restricted to those in the described embodiments. The composition, geometry, etc. of the fuel cell, the P-type thermoelectric element, the N-type thermoelectric element, etc. are not restricted to those in the described embodiments, either.

## Claims

1. An electric power generation device comprising at least one single chamber type fuel cell including an electrolyte, a fuel electrode joined to the electrolyte and an air electrode separated from the fuel electrode and joined to the electrolyte, said fuel cell being arranged in a fuel gas channel through which high-temperature fuel gas flows to generate electric power,
**characterized in that**,
the electric power generating device further comprises either a N-type or P-type thermoelectric element which is provided separately from the fuel cell and extends from inside of the fuel gas channel to outside of the fuel gas channel, wherein
in a case where the electric power generation device further comprises the N-type thermoelectric element, the air electrode of the fuel cell is a P-type thermoelectric element extending from inside of the fuel gas channel to outside of the fuel gas channel and electrically connected to the N-type thermoelectric element outside the fuel gas channel; and
in a case where the electric power generation device further comprises the P-type thermoelectric element, the fuel electrode of the fuel cell is an N-type thermoelectric element extending from inside of the fuel gas channel to outside of the fuel gas channel and electrically connected to the P-type thermoelectric element outside the fuel gas channel.

2. The electric power generation device according to claim 1,
**characterized in that**,
the fuel cell is a first fuel cell which includes the P-type thermoelectric element as the air electrode extending from inside of the fuel gas channel to outside of the fuel gas channel;
the electric power generation device further comprises a second fuel cell including an electrolyte, a fuel electrode joined to the electrolyte and an air electrode separated from the fuel electrode and joined to the electrolyte; and
the N-type thermoelectric element which is provided separately from the first fuel cell is the fuel electrode of the second fuel cell.

3. The electric power generation device according to claim 1,
**characterized in that**,
the air electrode of the fuel cell is the P-type thermoelectric element extending from inside of the fuel gas channel to outside of the fuel gas channel; and the fuel electrode of the fuel cell is placed completely inside the fuel gas channel.

4. The electric power generation device according to claim 1,
**characterized in that**,
the fuel electrode of the fuel cell is the N-type thermoelectric element extending from inside of the fuel gas channel to outside of the fuel gas channel; and the air electrode of the fuel cell is placed completely inside the fuel gas channel.

## Patentansprüche

1. Stromerzeugungsvorrichtung, umfassend mindestens eine Einkammerbrennstoffzelle mit einem Elektrolyt, einer mit dem Elektrolyt verbundenen Brennstoffelektrode und einer von der Brennstoffelektrode getrennten und mit dem Elektrolyt verbundenen Luftelektrode, wobei die Brennstoffzelle in einem zur Stromerzeugung von Hochtemperaturbrenngas durchströmten Brenngaskanal angeordnet ist,
**dadurch gekennzeichnet,**
**dass** die Stromerzeugungsvorrichtung des Weiteren entweder ein Thermoelement vom Typ N oder ein Thermoelement vom Typ P umfasst, das getrennt von der Brennstoffzelle vorgesehen ist und sich von innerhalb des Brenngaskanals nach außerhalb des Brenngaskanals erstreckt,
wobei
in dem Fall, dass die Stromerzeugungsvorrichtung des Weiteren das Thermoelement vom Typ N umfasst, die Luftelektrode der Brennstoffzelle ein Thermoelement vom Typ P ist, das sich von innerhalb des Brenngaskanals nach außerhalb des Brenngaskanals erstreckt und mit dem Thermoelement vom Typ N außerhalb des Brenngaskanals elektrisch verbunden ist; und
in dem Fall, dass die Stromerzeugungsvorrichtung des Weiteren das Thermoelement vom Typ P umfasst, die Brennstoffelektrode der Brennstoffzelle ein Thermoelement vom Typ N ist, das sich von innerhalb des Brenngaskanals nach außerhalb des Brenngaskanals erstreckt und mit dem Thermoelement vom Typ P außerhalb des Brenngaskanals elektrisch verbunden ist.

2. Stromerzeugungsvorrichtung nach Anspruch 1,
**dadurch gekennzeichnet,**
**dass** die Brennstoffzelle eine erste Brennstoffzelle ist, die das Thermoelement vom Typ P als sich von innerhalb des Brenngaskanals nach außerhalb des Brenngaskanals erstreckende Luftelektrode aufweist;
die Stromerzeugungsvorrichtung des Weiteren eine zweite Brennstoffzelle mit einem Elektrolyt, einer mit dem Elektrolyt verbundenen Brennstoffelektrode und einer von der Brennstoffelektrode getrennten und mit dem Elektrolyt verbundenen Luftelektrode umfasst; und
das getrennt von der ersten Brennstoffzelle vorgesehene Thermoelement vom Typ N die Brennstoffelektrode der zweiten Brennstoffzelle ist.

3. Stromerzeugungsvorrichtung nach Anspruch 1,
**dadurch gekennzeichnet,**
**dass** die Luftelektrode der Brennstoffzelle das sich von innerhalb des Brenngaskanals nach außerhalb des Brenngaskanals erstreckende Thermoelement vom Typ P ist; und
die Brennstoffelektrode der Brennstoffzelle vollständig innerhalb des Brenngaskanals angeordnet ist.

4. Stromerzeugungsvorrichtung nach Anspruch 1,
**dadurch gekennzeichnet,**
**dass** die Brennstoffelektrode der Brennstoffzelle das sich von innerhalb des Brenngaskanals nach außerhalb des Brenngaskanals erstreckende Thermoelement vom Typ N ist; und
die Luftelektrode der Brennstoffzelle vollständig innerhalb des Brenngaskanals angeordnet ist.

## Revendications

1. Dispositif de production d'énergie électrique comprenant au moins une pile à combustible de type à une chambre comportant un électrolyte, une électrode à combustible reliée à l'électrolyte et une électrode à air séparée de l'électrode à combustible et reliée à l'électrolyte, ladite pile à combustible étant disposée dans un conduit de gaz combustible par lequel du gaz combustible à haute température s'écoule afin de produire de l'énergie électrique,
**caractérisé en ce que**
le dispositif de production d'énergie électrique comprend en outre un élément thermoélectrique soit de type N soit de type P qui est fourni séparément de la pile à combustible et qui s'étend à partir de l'intérieur du conduit de gaz combustible vers l'extérieur du conduit de gaz combustible,
dans lequel
dans un cas où le dispositif de production d'énergie électrique comprend en outre l'élément thermoélectrique de type N, l'électrode à air de la pile à combustible est un élément thermoélectrique de type P s'étendant à partir de l'intérieur du conduit de gaz combustible vers l'extérieur du conduit de gaz combustible et étant connecté électriquement à l'élément thermoélectrique de type N en dehors du conduit de gaz combustible ; et
dans un cas où le dispositif de production d'énergie électrique comprend en outre l'élément thermoélectrique de type P, l'électrode à combustible de la pile à combustible est un élément thermoélectrique de type N s'étendant à partir de l'intérieur du conduit de gaz combustible vers l'extérieur du conduit de gaz combustible et étant connecté électriquement à l'élément thermoélectrique de type P en dehors du conduit de gaz combustible.

2. Dispositif de production d'énergie électrique selon la revendication 1, **caractérisé en ce que**
la pile à combustible est une première pile à combustible qui comporte l'élément thermoélectrique de type P comme électrode à air s'étendant à partir de l'intérieur du conduit de gaz combustible vers l'extérieur du conduit de gaz combustible ; le dispositif de production d'énergie électrique comprend en outre une deuxième pile à combustible comportant un électrolyte, une électrode à combustible reliée à l'électrolyte et une électrode à air séparée de l'électrode à combustible et reliée à l'électrolyte ; et
l'élément thermoélectrique de type N qui est fourni séparément de la première pile à combustible est l'électrode à combustible de la deuxième pile à combustible.

3. Dispositif de production d'énergie électrique selon la revendication 1, **caractérisé en ce que**
l'électrode à air de la pile à combustible est l'élément thermoélectrique de type P s'étendant à partir de l'intérieur du conduit de gaz combustible vers l'extérieur du conduit de gaz combustible ; et
l'électrode à combustible de la pile à combustible est disposée complètement à l'intérieur du conduit de gaz combustible.

4. Dispositif de production d'énergie électrique selon la revendication 1, **caractérisé en ce que**
l'électrode à combustible de la pile à combustible est l'élément thermoélectrique de type N s'étendant à partir de l'intérieur du conduit de gaz combustible vers l'extérieur du conduit de gaz combustible ; et
l'électrode à air de la pile à combustible est disposée complètement à l'intérieur du conduit de gaz combustible.
